# EUROPEAN PATENT SPECIFICATION

(11) **EP 2 243 856 B1**
(45) Date of publication and mention of the grant of the patent: **14.08.2013**
(21) Application number: 09158522.4
(22) Date of filing: 22.04.2009
(51) Int. Cl.: C23C 14/28, C23C 14/58, B23K 26/42, F16P 1/04

(54) **Device for high temperature pulsed laser deposition**
Vorrichtung zum gepulsten Hochtemperatur-Laserstrahlverdampfen
Dispositif de dépôt laser à impulsion haute température

(43) Date of publication of application: 27.10.2010
(73) Proprietor: Solmates B.V., 7522 NB Enschede (NL)
(72) Inventor: Broekmaat, Joska Johannes, 7511 DS, Enschede (NL); Janssens, Jan Arnoud, 7412 DL, Deventer (NL); Dekkers, Jan Mathijn, 7611 AN, Aadorp (NL)
(74) Representative: 't Jong, Bastiaan Jacob

(56) References cited:
- WO-A-03/032371
- US-A- 5 015 492
- US-A- 5 085 166
- US-A- 5 145 713
- US-A- 5 207 884
- US-B1- 6 270 861

## Description

The invention relates to a device for pulsed laser deposition according to the preamble of claim 1. Such devices are known from US 6270861 and US 5207884.

Pulsed laser deposition (PLD)is a known technique for arranging a coating on an object. With this technique material of a target material is ablated by a laser, such that a plasma plume of this target material is generated. This plasma plume then is deposited on a substrate resulting in a coating of the target material on the substrate.

PLD was at first developed for coating small substrate surfaces, typically 10 millimeters by 10 millimeters. This is typically used in research environments, where small substrates are coated with all kinds of materials with high thin film quality.

Resulting from this research a need to coat larger surfaces originated. This has resulted in innovative techniques with which surfaces having a typical diameter of several inches or more can be coated.

In order to coat some substrate materials with PLD with the correct material properties, such as crystal structure and texture, it is often necessary to heat the substrate to temperatures of typically 200°C - 1000°C.

When a small substrate surface of about 10x10 millimeters is heated up to 200°C - 1000°C, the heat radiation does not influence too much the target material arranged opposite to the substrate material. However, as the size of the substrate surface is increased, the heat radiation is also increased resulting in an unacceptable influence on the target material. This could result in early evaporation of components of the target material, such that the deposited coating on the substrate is of another composition than the original composition of the target material.

Another problem is target cracking. The target material could be of a material which has a poor heat conduction. When such a material is heated, the temperature differences in the material could lead to cracks in the material. Cracking can also occur if the target material undergoes a phase transition due to heating. Cracking can also occur if the bonding material between the target material and the target plate have different thermal expansion coefficients.

In other cases the target material has to be moved or rotated as a result of the used PLD technique. In such cases, cooling of a moving target is difficult.

A third problem with heating large substrate surfaces, is that not only the target material, but also the surrounding vacuum chamber and heat sensitive components, such as electric motors and rubber fittings, get heated to undesired temperatures.

Accordingly it is an object of the invention to reduces or even prevent the above mentioned disadvantages, such that high temperature large area PLD is possible.

This object is achieved according to the invention as claimed in claim 1

By providing a heat shield between the target and the heated substrate, the heat radiation of the substrate is at least partially blocked from the target material. A passage opening is necessary for at least the passage of the plasma plume generated at the target material. Depending on the angle at which the laser beam hits the target material and the distance of the target mount, substrate mount and heat shield, the passage could also be necessary for passage of the laser beam.

The cooling means can transport away the heat collected by the heat shield.

In an embodiment of the device according to the invention the heat shield comprises a first passage opening for the laser beam and a second passage opening for the plasma plume.

In a preferred embodiment of the device according to the invention the at least one passage opening is slot shaped. This shape is in particular of advantages, when the laser beam is scanned along the target material in order to cover a larger surface of the substrate material with the plasma plume.

It can occur that the plasma plume is not homogeneous. In such a case the edges of the plasma plume have properties, such as element distribution, particles energy as well as the amount of large particles (droplets), which are different from the properties at the center of the plume. The center part of the plume is the most homogenous part.

To prevent problems caused by an inhomogenously plasma plume the sides of the plasma plume can be blocked by the passage opening in the heat shield. The size of the passage opening is chosen such that in this configuration only a part of the plasma plume is deposited on the surface.

In another embodiment of the device according to the invention the heat shield is movable parallel to the substrate mount and target mount. When the laser beam is scanned along the target material and thus the plasma plume along the substrate surface, the passage opening is moved along in this embodiment by moving the heat shield.

In a very preferred embodiment of the device according to the invention, the substrate mount is rotatable around an axis perpendicular to the substrate mounting surface. With this PLD technique it is possible to cover large surface areas, while still covering with the heat shield a large part of substrate material and therefore shielding the target material from the radiated heat. Preferably, the cooling block is arranged around the heating means and the heat shield can be lowered on top of and into heat exchanging contact with the cooling block.

With this embodiment the substrate mount and heating means are for a large part enveloped by the cooling means, such that the remaining space of the vacuum chamber is shielded from the heat generated by the heating means and the heated substrate.

In another very preferred embodiment of the invention the passage opening in the heat shield is sealable, such that an air tight space is created. This air tight space is enclosed by the base of the vacuum chamber, the surrounding cooling means and the sealed of heat shield. Preferably a feed tube connects to the air tight space for feeding a gas into the air tight space.

To obtain the right texture, stoichiometry and crystalstructure thin films are often annealed after they are deposited. Annealing is often done in ex-situ furnaces however it also happens that thin films are annealed in-situ. Annealing can be done in all kinds of atmosphere such as O₂, Ar, H₂O-vapour, He but also very aggressive gasses such C1₂.

To prevent that these aggressive gases will be located on the complete vacuumchamber and react with components of the system such as motors and targets a small and closed annealing chamber can be created. With such an air tight space it is possible to perform the annealing treatment within the vacuum chamber, without having to expose the target material or other components in the vacuum chamber to the required temperatures for annealing.

In yet another embodiment of the device according to the invention the heat shield comprises an extraction cavity and is rotatable, such that the extraction cavity is positionable above the substrate. As the substrate mount, target mount and heating means are generally arranged in a vacuum chamber, the access to the substrate mount is limited for unmounting a substrate or mounting a new substrate. Typically, the substrate material is handled within the vacuum chamber with a loading stick.

According to the invention, a heat shield is arranged over the substrate material, limiting the access to the substrate material. With this embodiment is possible to rotate the heat shield, such that the extraction cavity is positioned over the substrate material providing access to this substrate material.

In another embodiment the substrate mount is movable away from the heat shield. This also provides additional space to the substrate for handling already coated substrate material and new substrate material.

An embodiment of the device according to the invention further comprises a vacuum chamber for housing at least the substrate mount, the target mount, the heating means and the heat shield.

These and other features of the invention will be elucidated in conjunction with the accompanying drawings.
Figure 1 shows schematically in perspective view an embodiment of the device according to the invention.
Figure 2 shows schematically in perspective view the embodiment of figure 1 in a second position.
Figure 3 shows in top view a second embodiment of a device according to the invention.
Figure 4 shows a side view of the device according to figure 3.
Figure 5 shows a side view of third embodiment of a device according to the invention.
Figure 6 shows a side view of the embodiment according to figure 4 in an annealing mode.

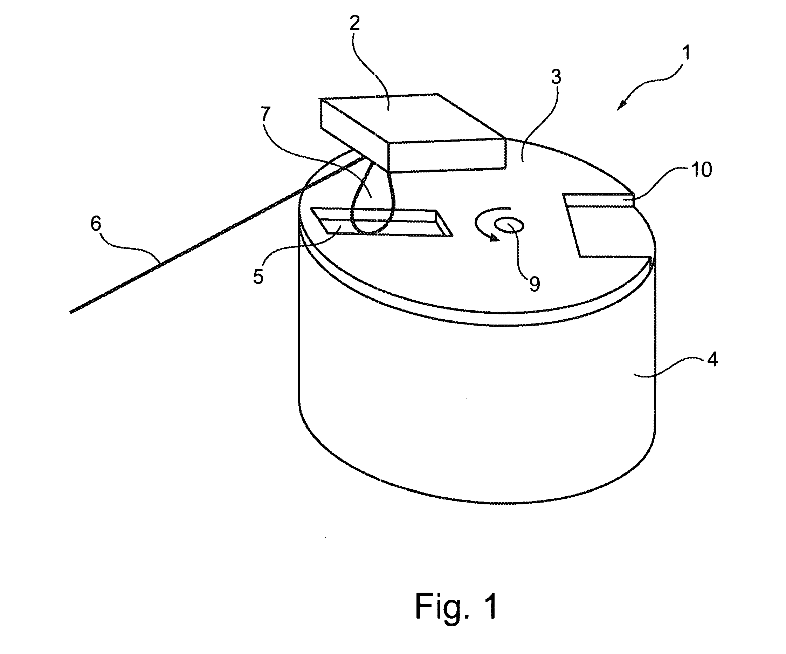

Figure 1 shows a first embodiment 1 of a device for pulsed laser deposition. This device 1 has a target mount 2, with a target material mounted thereon. Underneath the target 2, a rotatable heat shield 3 is arranged. This heat shield 3 rests on a peripheral wall 4, which is part of cooling means.

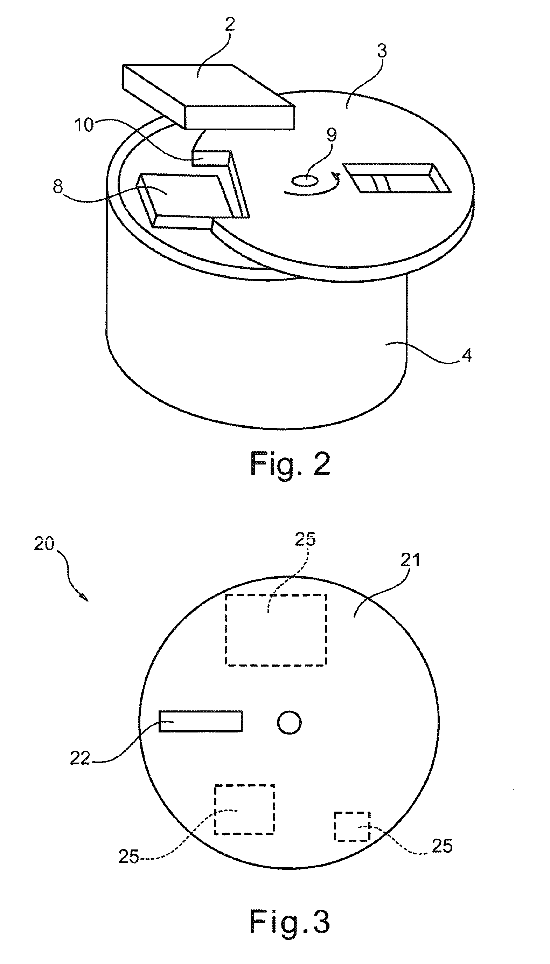

The heat shield 3 is provided with a slot shaped passage opening 5. When the target 2 is heated by the laser beam 6, a plasma plume 7 of target material is generated. This plasma plume 7 passes the passage opening 5 to the substrate material 8 (see figure 2).

In figure 2, the heat shield 3 is turned 180°. As the axis of rotation 9 is off-center, the heat shield 3 will not completely cover the peripheral wall 4. As the heat shield 3 also comprises an extraction cavity 10, sufficient room is available in this position of the heat shield 3 to remove or mount substrate material 8.

Although not shown, the peripheral wall 4 comprises a number of channels through which a coolant flows. A substantial amount of heat generated by the substrate material 8 is shielded by the heat shield 3 and is kept within the space delimited by the peripheral wall 4 and the heat shield 3. The coolant in the peripheral wall will absorb this heat and transport it to outside of the device 1.

In figure 3 a top view of a second embodiment 20 of a device according to the invention is shown. The device 20 comprises a heat shield 21 with a passage opening 22.

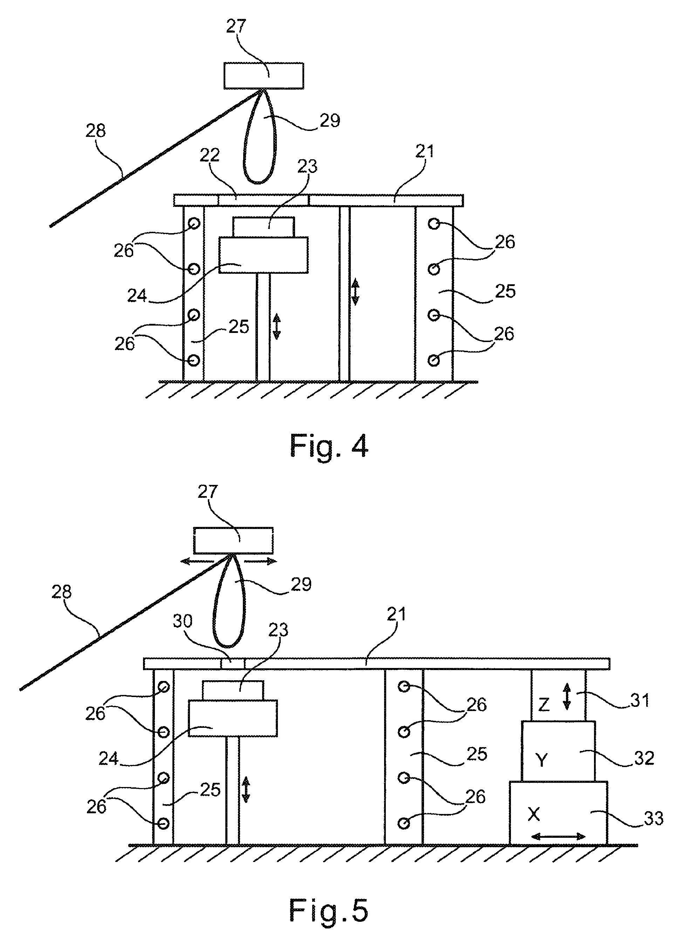

As shown in figure 4, which is a side view of the device according to figure 3, the passage opening 22 is arranged above the substrate material 23, which is mounted on a heater device 24. Above the passage opening 22 a target material mount 27 is arranged. Part of the target material 27 is heated by a laser beam 28, which generates a plasma plume 29. This plasma plume 29 flows through the passage opening 22 and is deposited on the substrate material 23.

The shield 21 rests on a number of cooling columns 25, which are each provided with a number of cooling channels 26. As the shield 21 is in heat exchanging contact with the cooling columns 25, the shield 21 is cooled by the coolant flowing through the cooling channels 26.

In order to change the substrate material 23 on the heater 24, the heater can be lowered and / or the shield 21 can be moved up. This results in sufficient space around the substrate material 23 to exchange the material.

In figure 5 a third embodiment of a device according to the invention is shown. This embodiment corresponds largely with the embodiment according to figures 3 and 4 and accordingly the same reference signs are used for the same features.

In the embodiment according to figure 5, the passage opening 30 is substantially smaller. The size of the opening corresponds to the size of the plasma plume 29.

The surface of the substrate 23 is covered by material from the plasma plume 29 by moving the laser beam 28 over the target material. This results in moving the plasma plume, such that the surface of the substrate 23 is covered.

As the passage opening 30 is only the size of the plasma plume 29, the heat shield 21 should be moved along with the plasma plume 29. This is effected by the positioners 31, 32, 33, which can move the heat shield 21 and therefore the passage opening 30 in all three dimensions according the movements of the plasma plume 29.

The advantage of this embodiment is that the opening 30 between the heated substrate 23 and the target material 27 is minimized.

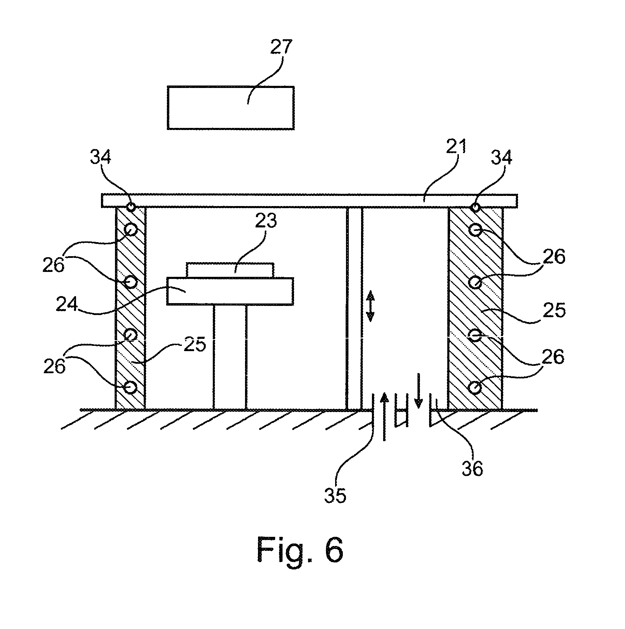

Figure 6 shows the device according to figure 4 in an annealing mode. In this annealing mode of the device, the heat shield 21 is completely sealed, including the passage opening. This rotatable disc 21 is arranged on the cooling columns 25 with a sealing 34 arranged in between. This results in an air tight chamber composed out of the vacuum chamber bottom, the cooling columns and the sealed heat shield.

In the bottom of the vacuum chamber two feed tubes 35, 36 are arranged. For example through the feed tube 35 a gas, like Ar-gas, is supplied to the air tight chamber. Then the heater device 24 on which the substrate 23 is mounted is used to create the desired temperature profile to have the desired annealing process.

After the annealing process is completed, the gas is pumped out of the air tight chamber through feed tube 36 and the heat shield is removed or at least the passage opening in the heat shield 21 is reopened.

## Claims

1. Device (1; 20; 30) for pulsed laser deposition, which device (1) comprises:
- a substrate mount with a substrate mounting surface for a substrate (8; 23);
- a target mount (2; 27) for a piece of target material arranged substantially parallel to and at a distance from the substrate mount (8; 23);
- a laser device for directing a laser beam (6; 28) on a piece of target material mounted on the target mount (2; 27), such that a plasma plume (7; 29) of target material is generated and deposits on the substrate (8; 23); and
- heating means (24) for heating a substrate (8; 23) mounted on the substrate mount; and
- a heat shield (3; 21) arranged between the substrate mount (8) and the target mount (2; 27) for shielding the target from being heated by the heated substrate (8; 23), wherein the heat shield (3; 21) comprises at least one passage opening (5; 22) for passage of at least the generated plasma plume (7; 29) and wherein the heat shield (3; 21) comprises cooling means for cooling the heat shield; **characterized by**
a cooling block (4; 25) and wherein the heat shield (3; 21) is displaceable into contact with the cooling block (4; 25).

2. Device (1; 20; 30) according to claim 1, wherein the heat shield comprises a first passage opening for the laser beam (6; 28) and a second passage (5; 22) opening for the plasma plume (7; 29).

3. Device (1; 20; 30) according to claim 1 or 2, wherein the at least one passage opening (5; 22) is slot shaped.

4. Device (1; 20; 30) according to claim 1 or 2, wherein the heat shield (3; 21) is movable parallel to the substrate mount (8; 23) and target mount (2; 27).

5. Device (1; 20; 30) according to any of the preceding claims, wherein the substrate mount (8; 23) is rotatable around an axis perpendicular to the substrate mounting surface.

6. Device (1; 20; 30) according to claim 1, wherein the cooling block (4; 25) is arranged around the heating means (24) and the heat shield (3; 21) can be lowered on top of and into heat exchanging contact with the cooling block (4; 25).

7. Device (1; 20; 30) according to claim 6, wherein the passage opening (5; 22) in the heat shield (3; 21) is sealable, such that an air tight space is created.

8. Device (1; 20; 30) according to claim 7, wherein a feed tube (35) connects to the air tight space for feeding a gas into the air tight space.

9. Device (1; 20; 30) according to any of the preceding claims, wherein the heat shield (3; 21) comprises a extraction cavity (10) and is rotatable, such that the extraction cavity (10) is positionable above the substrate (8; 23).

10. Device (1; 20; 30) according to any of the preceding claims, wherein the substrate mount (8; 23) is movable away from the heat shield (3; 21).

11. Device (1; 20; 30) according to any of the preceding claims, comprising a vacuum chamber for housing at least the substrate mount (8; 23), the target mount (2; 27), the heating means (24) and the heat shield (3; 21).

## Patentansprüche

1. Vorrichtung (1; 20; 30) zum Laserstrahlverdampfen, wobei die Vorrichtung (1) umfasst:
- eine Substratanbringung mit einer Substratanbringungsoberfläche für ein Substrat (8; 23);
- eine Targetanbringung (2;27) für ein Stück Targetmaterial, im Wesentlichen parallel zu und mit einem Abstand von der Substratanbringung (8; 23) angeordnet;
- eine Laservorrichtung zum Lenken eines Laserstrahls (6; 28) auf ein Stück Targetmaterial, angebracht auf der Targetanbringung (2; 27), derart, dass eine Plasmawolke (7; 29) aus Targetmaterial erzeugt wird und sich auf dem Substrat (8; 23) abscheidet; und
- Heizmittel (24) zum Heizen eines Substrats (8; 23), angebracht an der Substratanbringung; und
- ein Hitzeschild (3; 21), angeordnet zwischen der Substratanbringung (8) und der Targetanbringung (2; 27) zum Abschirmen des Targets vor einem Aufheizen durch das aufgeheizte Substrat (8; 23), wobei das Hitzeschild (3; 21) wenigstens eine Durchgangsöffnung (5; 22) zum Durchgang von wenigstens der erzeugten Plasmawolke (7; 29) umfasst und wobei das Hitzeschild (3; 21) Kühlmittel zum Kühlen des Hitzeschilds umfasst, **gekennzeichnet durch** einen Kühlblock (4; 25) und wobei das Hitzeschild (3; 21) in Kontakt mit dem Kühlblock (4; 25) verschiebbar ist.

2. Vorrichtung (1; 20; 30) nach Anspruch 1, wobei das Hitzeschild eine erste Durchgangsöffnung für den Laserstrahl (6; 28) und eine zweite Durchgangsöffnung (5; 22) für die Plasmawolke (7; 29) umfasst.

3. Vorrichtung (1; 20; 30) nach Anspruch 1 oder 2, wobei die mindestens eine Durchgangsöffnung (5; 22) schlitzförmig ausgebildet ist.

4. Vorrichtung (1; 20; 30) nach Anspruch 1 oder 2, wobei das Hitzeschild (3; 21) parallel zu der Substratanbringung (8; 23) und der Targetanbringung (2; 27) bewegbar ist.

5. Vorrichtung (1; 20; 30) nach einem der vorhergehenden Ansprüche, wobei die Substratanbringung (8; 23) rotierbar um eine Achse senkrecht zu der Substratanbringungsoberfläche ist.

6. Vorrichtung (1; 20; 30) nach Anspruch 1, wobei der Kühlblock (4; 25) um das Heizmittel (24) angeordnet ist und das Hitzeschild (3; 21) auf und in Wärmeaustauschkontakt mit dem Kühlblock (4; 25) abgesenkt werden kann.

7. Vorrichtung (1; 20; 30) nach Anspruch 6, wobei die Durchgangsöffnung (5; 22) in dem Hitzeschild (3; 21) derart abdichtbar ist, dass ein luftdichter Raum erzeugt wird.

8. Vorrichtung (1; 20; 30) nach Anspruch 7, wobei ein Zuführrohr (35) den luftdichten Raum zum Zuführen eines Gases in den luftdichten Raum verbindet.

9. Vorrichtung (1; 20; 30) nach einem der vorhergehenden Ansprüche, wobei das Hitzeschild (3; 21) einen Extraktionshohlraum (10) umfasst und rotierbar ist, so dass der Extraktionshohlraum (10) oberhalb des Substrats (8; 23) positionierbar ist.

10. Vorrichtung (1; 20; 30) nach einem der vorhergehenden Ansprüche, wobei die Substratanbringung (8; 23) von dem Hitzeschild (3; 21) wegbewegbar ist.

11. Vorrichtung (1; 20, 30) nach einem der vorhergehenden Ansprüche, umfassend eine Vakuumkammer für die Aufnahme von wenigstens der Substratanbringung (8; 23), der Targetanbringung (2; 27), des Heizmittels (24) und des Hitzeschilds (3; 21).

## Revendications

1. Dispositif (1 ; 20 ; 30) de dépôt par laser pulsé, lequel dispositif (1) comprend :
- un porte-substrat ayant une surface porte-substrat destinée à un substrat (8 ; 23) ;
- un porte-cible (2 ; 27), destiné à un morceau de matière-cible, agencé sensiblement parallèlement au porte-substrat (8 ; 23) et à une certaine distance de ce dernier ;
- un dispositif laser servant à diriger un faisceau laser (6 ; 28) sur un morceau de matière-cible monté sur le porte-cible (2 ; 27), de telle sorte qu'un panache de plasma (7 ; 29) de matière-cible est produit et se dépose sur le substrat (8 ; 23) ; et
- un moyen de chauffage (24) servant à chauffer un substrat (8 ; 23) monté sur le porte-substrat ; et
- un écran thermique (3 ; 21) agencé entre le porte-substrat (8) et le porte-cible (2 ; 27) pour empêcher que la cible soit chauffée par le substrat chauffé (8 ; 23), dans lequel l'écran thermique (3 ; 21) comprend au moins une ouverture de passage (5 ; 22) pour le passage au moins du panache de plasma produit (7 ; 29) et dans lequel l'écran thermique (3 ; 21) comprend un moyen de refroidissement destiné à refroidir l'écran thermique ; **caractérisé par** un bloc de refroidissement (4 ; 25) et dans lequel l'écran thermique (3 ; 21) peut être déplacé de façon à entrer en contact avec le bloc de refroidissement (4 ; 25).

2. Dispositif (1 ; 20 ; 30) selon la revendication 1, dans lequel l'écran thermique comprend une première ouverture de passage pour le faisceau laser (6 ; 28) et une seconde ouverture de passage (5 ; 22) pour le panache de plasma (7 ; 29).

3. Dispositif (1 ; 20 ; 30) selon la revendication 1 ou 2, dans lequel l'au moins une ouverture de passage (5 ; 22) est en forme de fente.

4. Dispositif (1 ; 20 ; 30) selon la revendication 1 ou 2, dans lequel l'écran thermique (3 ; 21) est mobile parallèlement au porte-substrat (8 ; 23) et au porte-cible (2 ; 27).

5. Dispositif (1 ; 20 ; 30) selon l'une quelconque des revendications précédentes, dans lequel le porte-substrat (8 ; 23) peut tourner autour d'un axe perpendiculaire à la surface porte-substrat.

6. Dispositif (1 ; 20 ; 30) selon la revendication 1, dans lequel le bloc de refroidissement (4 ; 25) est agencé autour du moyen de chauffage (24) et dans lequel l'écran thermique (3 ; 21) peut être abaissé sur le dessus du bloc de refroidissement (4 ; 25) de manière à établir avec ce dernier un contact s'accompagnant d'un échange de chaleur.

7. Dispositif (1 ; 20 ; 30) selon la revendication 6, dans lequel l'ouverture de passage (5 ; 22) ménagée dans l'écran thermique (3 ; 21) peut être fermée hermétiquement de manière à créer un espace étanche à l'air.

8. Dispositif (1 ; 20 ; 30) selon la revendication 7, dans lequel un tuyau d'alimentation (35) se raccorde à l'espace étanche à l'air pour amener un gaz à l'intérieur de l'espace étanche à l'air.

9. Dispositif (1 ; 20 ; 30) selon l'une quelconque des revendications précédentes, dans lequel l'écran thermique (3 ; 21) comprend une cavité d'extraction (10) et est rotatif, de telle sorte que la cavité d'extraction (10) peut être placée au-dessus du substrat (8 ; 23).

10. Dispositif (1 ; 20 ; 30) selon l'une quelconque des revendications précédentes, dans lequel le porte-substrat (8 ; 23) peut être éloigné de l'écran thermique (3 ; 21).

11. Dispositif (1 ; 20 ; 30) selon l'une quelconque des revendications précédentes, comprenant une chambre à vide destinée à abriter au moins le porte-substrat (8 ; 23), le porte-cible (2 ; 27), les moyens de chauffage (24) et l'écran thermique (3 ; 21).
